# FASCICULE DE BREVET EUROPEEN

(11) **EP 3 295 665 B1**
(45) Date de publication et mention de la délivrance du brevet: **27.02.2019**
(21) Numéro de dépôt: 16722193.6
(22) Date de dépôt: 11.05.2016
(51) Int. Cl.: H03M 1/12, H03M 1/56, H04N 5/374, H04N 5/3745, H04N 5/376, H04N 5/378

(54) **CIRCUIT DE LECTURE D'UN CAPTEUR À MATRICE DE PIXELS AVEC CONVERSION ANALOGIQUE - NUMÉRIQUE À HAUTE CADENCE D'ACQUISITION, ET CAPTEUR D'IMAGES COMPRENANT UN TEL CIRCUIT**
AUSLESESCHALTUNG FÜR EIN PIXELARRAYSENSOR MIT A/D-WANDLUNG MIT HOHER ERFASSUNGSGESCHWINDIGKEIT UND MIT SOLCHER SCHALTUNG VERSEHENER BILDSENSOR
READ-OUT CIRCUIT FOR A PIXEL ARRAY SENSOR WITH HIGH CAPTURE RATE A/D CONVERSION AND IMAGE SENSOR COMPRISING THE SAME

(30) Priorité: 12.05.2015 FR 1554214
(43) Date de publication de la demande: 21.03.2018
(73) Titulaire: Pyxalis, 38430 Moirans (FR)
(72) Inventeur: LIABEUF, Christian, 38500 Voiron (FR)
(74) Mandataire: Priori, Enrico
(86) Numéro de dépôt international: PCT/EP2016/060544
(87) Numéro de publication internationale: WO 2016/180872

(56) Documents cités:
- US-A1- 2007 080 838
- US-A1- 2015 076 325
- US-B2- 7 880 662

## Description

L'invention porte sur un circuit de lecture d'un capteur à matrice de pixels et de conversion analogique - numérique des signaux lus, ainsi que sur un capteur d'images comprenant un tel circuit de lecture. Elle vise à augmenter la cadence d'acquisition d'images sans sacrifier la résolution de conversion, c'est-à-dire le nombre de niveaux de luminosité de l'image numérique acquise ou, de manière équivalente, à améliorer la résolution de conversion sans réduire la cadence d'acquisition.

L'invention s'applique en particulier au cas d'une matrice de pixels actifs, notamment de type CMOS, mais elle peut s'appliquer de manière générale à tout capteur matriciel présentant une lecture « en pied de colonne ».

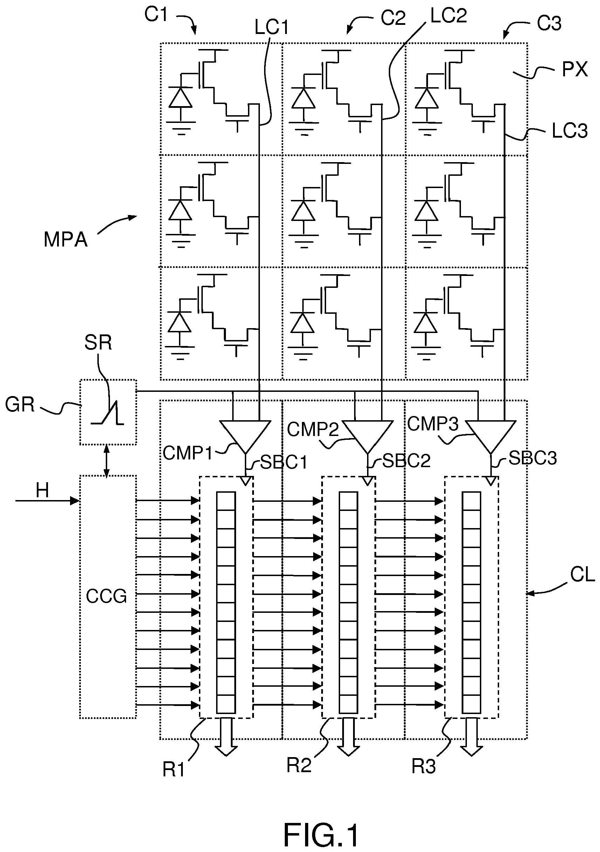

La figure 1 illustre un capteur à matrice de pixels actifs comprenant un circuit de lecture selon l'art antérieur.

La matrice MPA comprend une pluralité (9 sur l'exemple de la figure, plusieurs milliers dans la plupart des cas réels) de pixels actifs PX, généralement réalisés en technologie CMOS (métal - oxyde - semiconducteur complémentaire) organisés par rangées et par colonnes ; les colonnes sont identifiées par les références C1, C2 et C3. Chaque pixel comprend une photodiode qui génère des charges électriques lorsqu'elle est éclairée par de la lumière ; la photodiode accumule, pendant un temps dit d'intégration, les charges générées, qu'il est ensuite possible de lire directement ou par un noeud de stockage intermédiaire.

La matrice est lue comme une mémoire vive : tous les pixels d'une même colonne sont reliés à un même conducteur de lecture (LC1 pour la colonne C1 ; LC2 pour la colonne C2 ; LC3 pour la colonne C3) ; un signal de sélection de rangée (non représenté) sélectionne un seul pixel pour chaque colonne, qui transfère une tension représentative des charges accumulées sur le conducteur de lecture de la colonne correspondante.

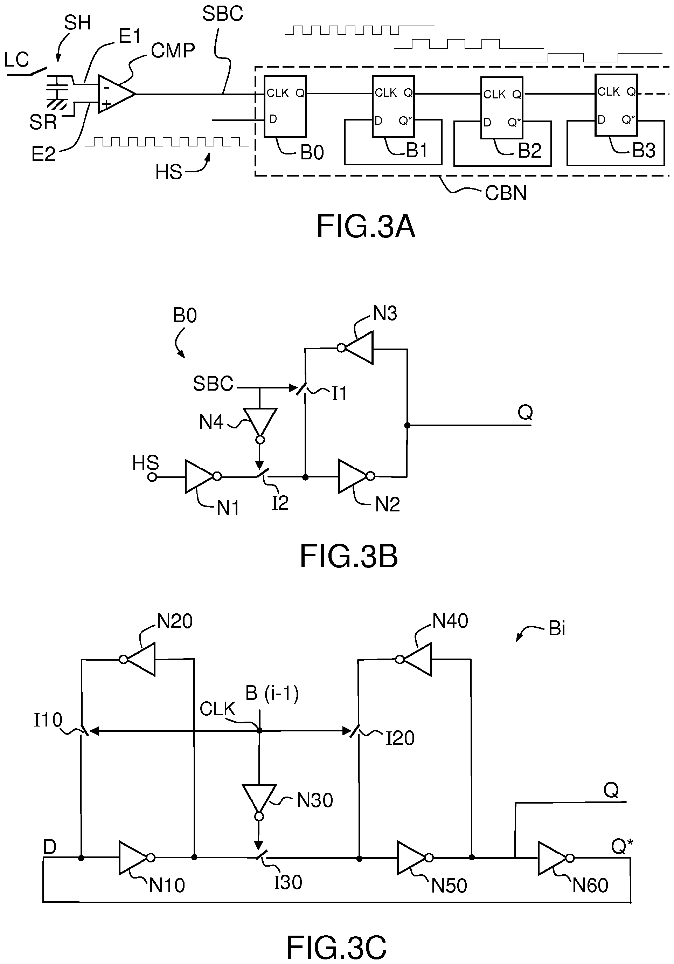

Au pied de chaque colonne, un échantillonneur-bloqueur respectif (non représenté sur la figure 1 ; référence SH sur la figure 3A) acquiert la tension sur le conducteur de lecture et la convertit au format numérique par un convertisseur du type rampe. Dans le mode de réalisation le plus simple, le signal de tension acquis par l'échantillonneur-bloqueur est fourni à une première entrée d'un comparateur analogique (CMP1 pour la colonne C1, CMP2 pour la colonne C2, CMP3 pour la colonne C3) qui reçoit, sur sa deuxième entrée, une rampe de tension SR commune a une pluralité de colonnes, dépassant en fin de conversion les tensions échantillonnées sur les conducteurs LC1, LC2, LC3... Le signal binaire de sortie du comparateur (SBC1, SBC2, SBC3) commute lorsque la rampe SR égalise la tension présente sur la première entrée du comparateur. On obtient ainsi une conversion tension - retard. D'autres architectures de conversion tension - retard existent et peuvent être appliquées à la conversion analogique - numérique des signaux issus d'un capteur à matrice.

Dans cette configuration, un signal d'horloge H pilote un compteur à code de Gray CCG commun à toutes les colonnes (le code de Gray est préféré au code binaire naturel car il est plus robuste vis-à-vis des erreurs dus à l'apparition d'états transitoires ; toutefois, l'utilisation d'un code binaire naturel, ou de tout autre type de code binaire, est également possible) pour effectuer un comptage qui démarre en même temps que la rampe de tension, ou avec un décalage temporel connu et contrôlable (sur la figure 1, une double flèche symbolise la synchronisation entre le générateur de rampe GR et le compteur à code de Gray CCG). D'une manière connue en soi, la synchronisation peut être réalisée par un séquenceur numérique qui envoie des signaux de départ simultanés (ou avec un décalage prédéterminé) au générateur de rampe et au compteur. Le code de Gray généré par le compteur CCG est propagé à un banc de registres à entrées parallèles et sorties séries, R1, R2, R3 - un par colonne. La commutation de chaque signal de sortie d'un comparateur - SBC1, SBC2, SBC3 - déclenche l'échantillonnage de la valeur du compteur dans le registre correspondant. Ainsi, chaque registre mémorise le code de Gray généré au moment où la rampe de tension commune à tous les comparateurs égalise le signal de tension correspondant à la colonne de pixels à laquelle il est associé.

On appelle circuit de lecture CL l'ensemble constitué par les échantillonneurs-bloqueurs, les comparateurs, les registres et, optionnellement, le générateur de rampe, le compteur à code de Gray et/ou le générateur de signal d'horloge.

Le circuit de lecture du capteur d'images de la figure 1 présente une structure simple, peu consommatrice de puissance et facile à mettre en oeuvre. Le résultat de la conversion analogique - numérique est monotone, présente une bonne linéarité et une faible dispersion de colonne à colonne. Son inconvénient est qu'il est difficile d'obtenir à la fois une bonne résolution de conversion (par exemple, 14 bits) et une cadence d'acquisition élevée (inférieure à 10 µs). En effet, pour une résolution de 14 bits, il faut compter jusqu'à 16384. Si le signal d'horloge présente une fréquence de 400MHz, cela nécessite environ 41µs. Diminuer le temps de conversion d'un facteur 8 - ce qui permettrait une cadence d'acquisition d'environ 1 image / 5 µs - nécessiterait de multiplier par 8 la fréquence d'horloge (3.2GHz), ce qui n'est pas possible, en tout cas avec les technologies électroniques utilisées pour réaliser les capteurs à matrice active. De plus, lorsque l'on augmente la fréquence d'horloge, il devient difficile de propager le code de Gray de façon synchrone sur des distances qui peuvent être importantes (plusieurs millimètres) si le nombre de colonnes de la matrice est élevé.

Une structure alternative utilise un compteur distinct (Gray ou binaire naturel) pour chaque colonne. Cela ne permet pas d'augmenter de manière significative la cadence d'acquisition des images, car il faut toujours générer une horloge à fréquence élevée et la propager de manière synchrone sur une distance importante.

Ces architectures sont décrites dans le document US 7,880,662.

Le document EP 2 221 975 décrit un circuit de lecture d'un capteur à matrice de pixels actifs comprenant une horloge locale pour chaque colonne. Comme le signal d'horloge ne doit pas être propagé, sa fréquence peut être plus élevée. Par contre, ce circuit met en oeuvre un mécanisme complexe pour s'affranchir des erreurs de synchronisation entre les différentes horloges locales.

L'invention vise à surmonter les inconvénients de l'art antérieurs. Plus particulièrement, elle vise à procurer un circuit de lecture permettant d'atteindre une cadence d'acquisition d'images élevée sans sacrifier la résolution de conversion et par des moyens plus simples que ceux mis en oeuvre dans le circuit du document EP 2 221 975 précité.

Conformément à l'invention, ce but est atteint par l'utilisation d'une horloge commune aux différentes colonnes, dite horloge primaire ou de référence, présentant une fréquence relativement basse, et des multiplicateurs de fréquence locaux au pied de chaque colonne qui génèrent des signaux d'horloge dits secondaires, ou locaux, pilotant des compteurs respectifs. Seule l'horloge primaire doit être propagée et, comme elle présente une fréquence relativement basse, cela ne pose pas de difficulté particulière. L'utilisation de multiplicateurs de fréquence pilotés par une horloge primaire commune permet d'assurer la synchronisation des signaux d'horloge secondaires. Par ailleurs, selon un mode de réalisation avantageux de l'invention, le comptage peut être assuré par des compteurs binaires naturels modifiés dans lesquels le bit le moins significatif suit l'horloge secondaire, au lieu de commuter à chaque front montant ou descendant, permettant d'atteindre une cadence de comptage double de la fréquence d'horloge. Cela permet de gagner un facteur deux en cadence d'acquisition des images, ou un bit de résolution de conversion pour une cadence donnée.

Ainsi, un objet de l'invention est un circuit de lecture d'un capteur à matrice de pixels comprenant :
- une pluralité de circuits convertisseurs tension - retard, configurés pour recevoir sur une entrée une valeur de tension représentative de la tension d'un conducteur de lecture d'une colonne de pixels respective de ladite matrice et pour fournir en sortie un signal binaire dit de comparaison, présentant une commutation à un instant fonction de la valeur de tension en entrée ;
caractérisé en ce qu'il comprend également :
- une pluralité de circuits multiplicateurs de fréquence, chacun associé à un groupe d'au moins un dit circuit convertisseur tension - retard, présentant des entrées respectives reliées à une ligne de transmission d'horloge commune destinée à propager un signal d'horloge dit primaire, et des sorties respectives pour des signaux d'horloge dits secondaires de fréquence multiple dudit signal d'horloge primaire, ces circuits étant configurés pour multiplier la fréquence du signal d'horloge primaire présent à leur entrée par un même facteur multiplicatif ; et
- une pluralité de compteurs binaires, un pour chaque dit circuit convertisseurs tension - retard, ayant un même nombre de bits de comptage et configurés pour recevoir sur une première entrée un dit signal d'horloge secondaire, et sur une seconde entrée le signal binaire de comparaison fourni par le circuit convertisseur tension - retard correspondant, chaque dit compteur étant configuré pour effectuer un comptage à une cadence dictée par ledit signal d'horloge secondaire jusqu'à une commutation dudit signal binaire de comparaison.

Selon des modes de réalisation avantageux d'un tel circuit de lecture :
- Chaque dit circuit convertisseurs tension - retard peut être du type à simple rampe et comprendre un générateur de rampe linéaire de tension et un comparateur analogique configuré pour comparer une tension constante à ladite rampe linéaire de tension.
- Chaque dit circuit multiplicateur de fréquence peut être associé à un et un seul circuit convertisseur tension - retard.
- Chaque dit compteur binaire peut être un compteur binaire naturel comprenant :
   - un élément de mémoire de type verrou, présentant une première entrée configurée pour recevoir un dit signal d'horloge secondaire et formant ladite première entrée du compteur binaire naturel, une seconde entrée configurée pour recevoir le signal binaire de comparaison fourni par le circuit convertisseur tension - retard correspondant, et une sortie, ledit élément de mémoire étant configuré pour transmettre à sa sortie le signal présent sur sa première entrée lorsque le signal présent sur sa deuxième entrée prend une première valeur, et pour maintenir inchangé le signal présent sur sa sortie lorsque le signal présent sur sa deuxième entrée prend une deuxième valeur complémentaire de la première ; et
   - une pluralité de bascules montées en diviseurs par deux et connectées en cascade, une entrée d'horloge de la première de ces bascules étant connectée à la sortie dudit élément de mémoire.
- Chaque dit circuit multiplicateur de fréquence peut comprendre une boucle à verrouillage de phase numérique incluant un diviseur de fréquence dans sa boucle de rétroaction.
- Un échantillonneur - bloqueur peut être agencé sur l'entrée de chaque dit circuit convertisseur tension - retard.
- Le circuit de lecture peut comporter également un générateur dudit signal d'horloge primaire, relié à ladite ligne de transmission d'horloge commune.
- Lesdits circuits multiplicateurs de fréquence peuvent présenter un facteur multiplicatif compris entre 2 et 16.

Un autre objet de l'invention est un capteur d'images comprenant un capteur à matrice de pixels, comprenant une pluralité de pixels agencés par rangées et par colonnes, chaque dite colonne ayant un conducteur de lecture respectif, et un circuit de lecture de ladite matrice selon l'une des revendications précédentes, lesdites entrées des circuits convertisseurs tension - retard dudit circuit de lecture étant reliées à des conducteurs de lecture respectifs des colonnes de pixels de la matrice.

Ledit capteur à matrice de pixels et ledit circuit de lecture peuvent être co-intégrés de manière monolithique.

Lesdits pixels peuvent être en particulier des pixels actifs.

D'autres caractéristiques, détails et avantages de l'invention ressortiront à la lecture de la description faite en référence aux dessins annexés donnés à titre d'exemple et qui représentent, respectivement :
- La figure 1, décrite plus haut, le schéma fonctionnel d'un capteur d'images à matrice de pixels actifs comprenant un circuit de lecture connu de l'art antérieur ;
- La figure 2, le schéma fonctionnel d'un capteur d'images à matrice de pixels actifs comprenant un circuit de lecture selon un mode de réalisation de l'invention ;
- Les figures 3A, 3B et 3C, les schémas électriques simplifiés de différentes portions du circuit de lecture de la figure 2 ; et
- La figure 4, des chronogrammes illustrant le fonctionnement de ce circuit de lecture.

Dans les figures, les mêmes références désignent des éléments identiques ou équivalents.

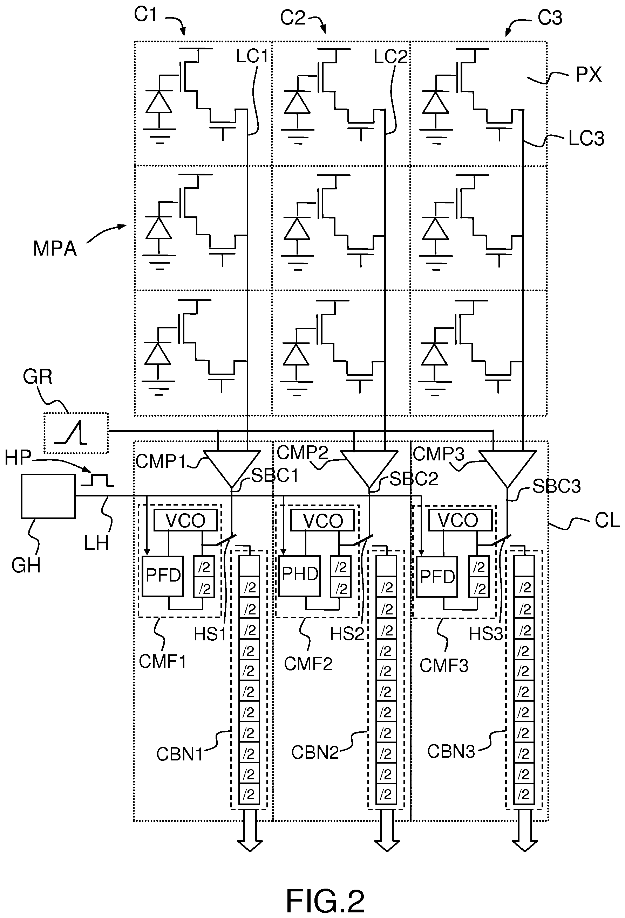

On peut remarquer que, dans le schéma de la figure 2, il n'y a plus de propagation d'un code binaire : le comptage est généré localement au pied de chaque colonne par des compteurs binaires naturels CBN1, CBN2, CBN3 (un comptage de Gray, ou tout autre type de comptage binaire, serait également envisageable). Ces compteurs sont pilotés par des signaux d'horloge secondaires (locaux) HS1, HS2, HS3 générés localement. Contrairement au cas du document EP 2 221 975 précité, cependant, les signaux d'horloge secondaires ne sont pas générés par des oscillateurs locaux indépendants, mais sont obtenus par multiplication de fréquence d'un signal d'horloge primaire, ou de référence, HP, généré par un oscillateur GH et propagé à travers le circuit de lecture le long d'une ligne d'horloge LH.

Dans le mode de réalisation de la figure 2, la multiplication de fréquence est assurée par des boucles à verrouillage de phase numériques comprenant un comparateur de phase PFD, un oscillateur commandé en tension VCO et un diviseur de fréquence par un facteur fixe ou variable. Dans l'exemple de la figure, ce facteur vaut 4 et est obtenu par connexion en cascade de deux bascules montées en diviseurs de fréquence par 2, symbole « /2 ».

Aussi bien l'horloge primaire que les horloges secondaires présentent des formes d'onde en créneau. Il n'est cependant pas essentiel que ces formes d'onde présentent un rapport cyclique de 50% comme dans le cas de l'exemple.

Comme dans le circuit de la figure 1, une commutation du signal SBC1, SBC2, SBC3 d'un comparateur CMP1, CMP2, CMP3 arrête le comptage par le compteur correspondant CBN1, CBN2, CBN3.

Les figures 3A à 3C illustrent la structure d'un compteur CBN selon un mode de réalisation avantageux de l'invention.

Il est connu qu'un compteur binaire naturel peut être obtenu en connectant en cascade des bascules (B1, B2, B3 sur la figure 3A) montées en diviseurs par 2. Il peut s'agir par exemple de bascules de type D, dans lesquelles :
- la sortie complémentaire Q* est rebouclée sur l'entrée D ;
- la sortie Q est reliée à l'entrée d'horloge CLK de la bascule suivante (sauf pour la dernière bascule de la cascade).

Le compteur CBN adopte cette structure, sauf en ce que la première bascule, qui correspond au bit de comptage le moins significatif, est remplacée par un élément de mémoire BO de type verrou (« latch » en anglais) qui recopie à sa sortie le signal d'horloge HS tant que le signal de comparaison SBC présente une première valeur (par exemple une valeur basse) et fige sa sortie lorsque SBC prend une seconde valeur complémentaire de la première (une valeur haute, dans l'exemple considéré). Ainsi, le compteur binaire naturel CBN de la figure 3A commute deux fois pour chaque cycle d'horloge, alors que dans le cas d'un compteur constitué d'une simple connexion en cascade de bascules « D », qui commutent uniquement sur front montant ou descendant, la valeur de comptage est égale au nombre d'impulsions d'horloge reçues. L'utilisation d'un tel élément de mémoire de type verrou à la place d'une bascule pour le bit le moins significatif permet, pour une fréquence d'horloge donnée, de diviser par deux le temps nécessaire à compter jusqu'à 2^{N}-1, N étant le nombre de bits de comptage. Dans l'application considérée ici, cela permet de multiplier par deux la cadence d'acquisition d'images à résolution de conversion inchangée (c'est-à-dire pour le même nombre N de bits) ou de gagner un bit de résolution à cadence inchangée.

La figure 3B illustre la structure et le fonctionnement de l'élément BO. Le signal binaire de comparaison SBC pilote les interrupteurs l1 et l2, ce dernier par l'intermédiaire de l'inverseur N4. Dans l'exemple considéré, tant que SBC est à un niveau bas (ce qui signifie que la rampe de tension SR est inférieure à la tension aux bornes de l'échantillonneur - bloqueur SH relié au conducteur de lecture de colonne LC, cf. la figure 3A), interrupteur I1 est ouvert et l'interrupteur I2 fermé. Le signal d'horloge HS parvient à la sortie Q à travers les deux inverseurs N1, N2 : l'élément est donc transparent. L'inverseur N1 est optionnel, dans la mesure où la sortie de l'élément BO pourrait être simplement inversée. Lorsque la rampe de tension SR égalise la tension aux bornes de l'échantillonneur - bloqueur SH, le signal de comparaison SBC passe à un niveau haut, I2 s'ouvre et I1 se ferme. Ainsi, l'horloge HS est déconnecté de la boucle et la sortie Q garde la valeur qu'elle avait lors de la commutation, valeur qui est stockée dans le point mémoire formé par les inverseurs N2 et N3. Si N1 est présent, l'interrupteur I1 pourrait être omis, au pris d'une fluctuation de courant (« glitch ») lors de la commutation.

La figure 3C illustre la structure d'une bascule Bi (i compris entre 1 et N). Le signal présent à l'entrée d'horloge CLK de la bascule est issu de la sortie Q de la bascule B(i-1) - de l'élément de mémoire BO si i=1 ; la sortie inversée Q* est rebouclée sur l'entrée D. Les interrupteurs I10, I20 et I30 sont pilotés par le signal CLK - le dernier par l'intermédiaire de l'inverseur N30. Le fonctionnement du circuit, qui comprend également les inverseurs N10, N20 (formant un premier point mémoire), N40, N50 (formant un second point mémoire) et N60 (permettant d'obtenir la sortie inversée Q*) - est celui d'une bascule D classique.

Il est entendu que les schémas des figures 3B et 3C sont simplifiés, et présentés uniquement dans un but explicatif.

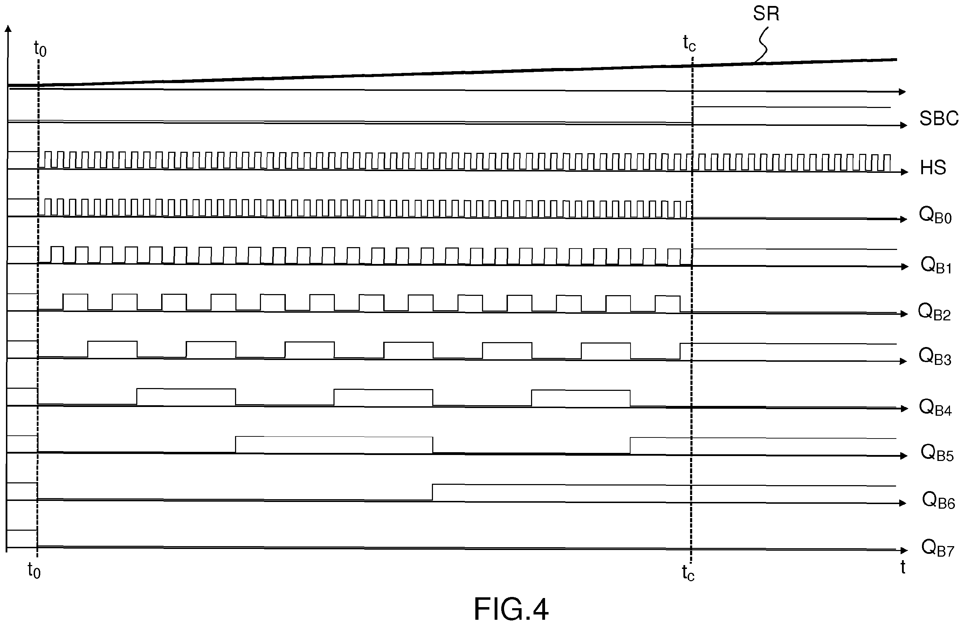

Les chronogrammes de la figure 4 illustrent le fonctionnement du circuit de lecture.

Le premier chronogramme à partir du haut illustre la rampe de tension SR, qui démarre au temps t₀.

Le signal binaire de comparaison SBC (deuxième chronogramme) prend initialement une valeur basse, puis commute à une valeur haute au temps t_{c}.

Le troisième chronogramme illustre le signal d'horloge secondaire HS.

Le quatrième chronogramme illustre le signal de sortie de l'élément de mémoire BO - désigné par Q_{B0} - qui représente le bit le moins significatif et suit l'horloge secondaire entre t₀ et t_{c}.

Les autres chronogrammes illustrent les signaux de sortie des bascules B1 - B7 (Q₁ - Q_{B7}) présentant chacun une fréquence divisée par deux par rapport à celle du chronogramme précédent.

Le signal d'horloge primaire n'est pas représenté ; toutefois on notera qu'il présente une fréquence inférieure à celle de HS d'un facteur 4, c'est-à-dire la même fréquence que Q_{B2}.

Conformément à l'invention, avec une horloge primaire à 400 MHz on peut générer des horloges secondaires à 1,6 GHz, correspondant directement au bit le moins significatif, ce qui permet une cadence d'acquisition de l'ordre d'une rangée toutes les 5 µs avec une résolution de 14 bits. Avec le circuit de lecture de la figure 1, pour obtenir ces performances il faudrait une horloge de compteur à 3,2 GHz, qui ne permettrait pas au compteur d'être propagé de manière synchrone. Pour une fréquence d'horloge propagée (primaire) donnée, l'architecture de la figure 2 multiplie la cadence d'acquisition des images d'un facteur 8 : un facteur 4 obtenu grâce aux circuits multiplicateurs de fréquence CMF1 - CMF3 et un autre facteur 2 dû à l'utilisation du compteur binaire naturel des figures 3A - 3C.

L'invention a été décrite en référence à un mode de réalisation particulier, mais de nombreuses variantes sont envisageables. Par exemple :
- Comme cela a été mentionné plus haut, il n'est pas essentiel que les pixels de la matrice soient actifs. Il suffit qu'ils permettent une lecture « en pied de colonne ».
- Comme cela a également été mentionné plus haut, d'autres circuits convertisseur tension - retard que celui décrit peuvent être utilisés. Un tel circuit comprendra le plus souvent un comparateur analogique et un générateur de rampe, et avantageusement au moins un échantillonneur - bloqueur, mais ces éléments peuvent être agencés autrement que dans l'exemple de la figure 2. Par exemple, un circuit convertisseur tension - retard pourrait réaliser une comparaison entre le signal d'entrée additionné à la rampe linéaire de tension avec une tension de référence.
- Un seul circuit multiplicateur de fréquence peut fournir l'horloge secondaire à une pluralité (mais pas à la totalité) de circuits convertisseur tension - retard ; il faut néanmoins que l'horloge secondaire demeure un signal « local » ; ainsi, de préférence, un circuit multiplicateur de fréquence sera associé à un nombre de circuits convertisseur tension - retard inférieur ou égal à 16.
- Afin de minimiser la consommation, la commutation d'un circuit convertisseur tension - retard peut provoquer l'arrêt du circuit multiplicateur de fréquence associé. Si plusieurs circuits convertisseurs tension - retard sont associés à un même circuit multiplicateur de fréquence, ce dernier ne sera arrêté que lorsque tous les convertisseurs associés auront commuté.
- Le facteur de multiplication de fréquence entre le signal d'horloge primaire et les signaux d'horloge secondaire ne doit pas nécessairement être égal à 4. Avantageusement, il peut être supérieur à 2, et par exemple compris entre 2 et 16. Le fait qu'il soit exprimé par une puissance de deux est avantageux du point de vue de la simplicité de réalisation, mais n'est pas essentiel.
- Les circuits multiplicateurs de fréquence ne doivent pas nécessairement être basés sur des boucles à verrouillage de phase. En effet, une synchronisation de n'est pas nécessaire ici ; on pourrait donc utiliser tout circuit multiplicateur de fréquence, qu'il soit analogique, purement numérique ou hybride.
- D'autres architectures de compteurs binaires, naturels ou de Gray, peuvent être utilisées. Le comptage pourrait même être à rebours.

Avantageusement, un circuit de lecture selon l'invention peut présenter une structure modulaire, les circuits convertisseurs tension - retard, les circuits multiplicateurs de fréquence et les compteurs associés aux différentes colonnes de la matrice de pixels actifs étant identiques entre eux. Cependant, une simple identité fonctionnelle peut suffire.

Avantageusement, le circuit de lecture (incluant ou pas le générateur d'horloge primaire et, le cas échéant, le générateur de rampe) et la matrice de pixels actifs peuvent être co-intégrés, typiquement en technologique CMOS, mais cela n'est pas indispensable.

## Revendications

1. Circuit de lecture (CL) d'un capteur à matrice de pixels (MPA) comprenant :
- une pluralité de circuits convertisseurs tension - retard, configurés pour recevoir sur une entrée (E1) une valeur de tension représentative de la tension d' un conducteur de lecture (LC, LC1 - LC3) d'une colonne (C1 - C3) de pixels (PX) respective de ladite matrice et pour fournir en sortie un signal binaire dit de comparaison (SBC), présentant une commutation à un instant fonction de la valeur de tension en entrée ;
**caractérisé en ce qu'**il comprend également :
- une pluralité de circuits multiplicateurs de fréquence (CMF1 - CMF3), chacun associé à un groupe d'au moins un dit circuit convertisseur tension - retard, présentant des entrées respectives reliées à une ligne de transmission d'horloge commune (LH) destinée à propager un signal d'horloge dit primaire (HP), et des sorties respectives pour des signaux d'horloge dits secondaires (HS, HS1 - HS3) de fréquence multiple dudit signal d'horloge primaire, ces circuits étant configurés pour multiplier la fréquence du signal d'horloge primaire présent à leur entrée par un même facteur multiplicatif ; et
- une pluralité de compteurs binaires (CBN, CBN1 - CBN3), un pour chaque dit circuit convertisseurs tension - retard, ayant un même nombre de bits de comptage et configurés pour recevoir sur une première entrée (D) un dit signal d'horloge secondaire, et sur une seconde entrée (CLK) le signal binaire de comparaison fourni par le circuit convertisseur tension - retard correspondant, chaque dit compteur étant configuré pour effectuer un comptage à une cadence dictée par ledit signal d'horloge secondaire jusqu'à une commutation dudit signal binaire de comparaison.

2. Circuit de lecture selon la revendication 1 dans lequel chaque dit circuit convertisseurs tension - retard est du type à simple rampe et comprend un générateur de rampe linéaire de tension et un comparateur analogique configuré pour comparer une tension constante à ladite rampe linéaire de tension.

3. Circuit de lecture selon l'une des revendications précédentes, dans lequel chaque dit circuit multiplicateur de fréquence est associé à un et un seul circuit convertisseur tension - retard.

4. Circuit de lecture selon l'une des revendications précédentes, dans lequel chaque dit compteur binaire est un compteur binaire naturel comprenant :
- un élément de mémoire (B0) de type verrou, présentant une première entrée configurée pour recevoir un dit signal d'horloge secondaire et formant ladite première entrée du compteur binaire naturel, une seconde entrée configurée pour recevoir le signal binaire de comparaison fourni par le circuit convertisseur tension - retard correspondant, et une sortie, ledit élément de mémoire étant configuré pour transmettre à sa sortie le signal (HS) présent sur sa première entrée lorsque le signal (SBC) présent sur sa deuxième entrée prend une première valeur, et pour maintenir inchangé le signal présent sur sa sortie lorsque le signal présent sur sa deuxième entrée prend une deuxième valeur complémentaire de la première ; et
- une pluralité de bascules (B1, B2, B3) montées en diviseurs par deux et connectées en cascade, une entrée d'horloge de la première de ces bascules étant connectée à la sortie dudit élément de mémoire.

5. Circuit de lecture selon l'une des revendications précédentes dans lequel chaque dit circuit multiplicateur de fréquence comprend une boucle à verrouillage de phase numérique incluant un diviseur de fréquence dans sa boucle de rétroaction.

6. Circuit de lecture selon l'une des revendications précédentes dans lequel un échantillonneur - bloqueur (SH) est agencé sur l'entrée (E1) de chaque dit circuit convertisseur tension - retard.

7. Circuit de lecture selon l'une des revendications précédentes comprenant également un générateur (GH) dudit signal d'horloge primaire, relié à ladite ligne de transmission d'horloge commune.

8. Circuit de lecture selon l'une des revendications précédentes dans lequel lesdits circuits multiplicateurs de fréquence présentent un facteur multiplicatif compris entre 2 et 16.

9. Capteur d'images comprenant un capteur à matrice de pixels (MPA), comprenant une pluralité de pixels (PX) agencés par rangées et par colonnes, chaque dite colonne (C1, C2, C3) ayant un conducteur de lecture (LC, LC1 - LC3) respectif, et un circuit de lecture (CL) de ladite matrice selon l'une des revendications précédentes, lesdites entrées des circuits convertisseurs tension - retard dudit circuit de lecture étant reliées à des conducteurs de lecture respectifs des colonnes de pixels de la matrice.

10. Capteur d'images selon la revendication 9 dans lequel ledit capteur à matrice de pixels et ledit circuit de lecture sont co-intégrés de manière monolithique.

11. Capteur d'images selon l'une des revendications 9 ou 10, dans lequel lesdits pixels sont des pixels actifs.

## Patentansprüche

1. Leseschaltung (CL) für einen Pixelmatrixsensor (MPA), die Folgendes umfasst:
- mehrere Spannung-in-Verzögerung-Wandlerschaltungen, konfiguriert zum Empfangen eines Spannungswerts an einem Eingang (E1), der die Spannung eines Leseleiters (LC, LC1 - LC3) einer jeweiligen Spalte (C1 - C3) von Pixeln (PX) der Matrix repräsentiert und am Ausgang ein binäres Signal (SBC), genannt Vergleichssignal, anlegt, mit einer Schaltung zu einem Zeitpunkt in Abhängigkeit von dem Spannungswert am Eingang;
**dadurch gekennzeichnet, dass** sie auch Folgendes umfasst:
- mehrere Frequenzvervielfacherschaltungen (CMF1 - CMF3), jeweils assoziiert mit einer Gruppe von wenigstens einer genannten Spannung-in-Verzögerung-Wandlerschaltung mit jeweiligen Eingängen, verbunden mit einer gemeinsamen Taktübertragungsleitung (LH) zum Ausbreiten eines sogenannten primären Taktsignals (HP), und jeweilige Ausgänge für sogenannte sekundäre Mehrfachfrequenztaktsignale (HS, HS1 - HS3) des primären Taktsignals, wobei diese Schaltungen zum Multiplizieren der Frequenz des primären Taktsignals an ihrem Eingang mit einem selben Multiplikationsfaktor konfiguriert sind; und
- mehrere binäre Zähler (CBN, CBN1 - CBN3), einen für jede Spannung-in-Verzögerung-Wandlerschaltung, mit einer gleichen Anzahl von Zählbits und konfiguriert zum Empfangen eines sekundären Taktsignals am ersten Eingang (D), und dem binären Vergleichssignal an einem zweiten Eingang (CLK), geliefert von der entsprechenden Spannung-in-Verzögerung-Wandlerschaltung, wobei jeder Zähler zum Bewirken einer Zählung mit einer Rate konfiguriert ist, diktiert durch das sekundäre Taktsignal bis zu einer Schaltung des binären Vergleichssignals.

2. Leseschaltung nach Anspruch 1, bei der jede Spannung-in-Verzögerung-Wandlerschaltung vom Typ mit einfacher Rampe ist und einen Generator mit linearer Spannungsrampe und einen analogen Komparator umfasst, konfiguriert zum Vergleichen einer konstanten Spannung mit der linearen Spannungsrampe.

3. Leseschaltung nach einem der vorherigen Ansprüche, wobei jede Frequenzmultiplikatorschaltung mit einer einzigen Spannung-in-Verzögerung-Wandlerschaltung assoziiert ist.

4. Leseschaltung nach einem der vorherigen Ansprüche, bei der jeder binäre Zähler ein natürlicher binärer Zähler ist, der Folgendes umfasst:
- ein Speicherelement (B0) des Sperrtyps mit einem ersten Eingang, konfiguriert zum Empfangen eines sekundären Taktsignals und den ersten Eingang des natürlichen binären Zählers bildend, einem zweiten Eingang, konfiguriert zum Empfangen des binären Vergleichssignals, geliefert von der entsprechenden Spannung-in-Verzögerung-Wandlerschaltung, und einem Ausgang, wobei das Speicherelement zum Übertragen, zu seinem Ausgang, des Signals (HS) konfiguriert ist, das an seinem ersten Eingang anliegt, wenn das Signal (SBC) an seinem zweiten Eingang einen ersten Wert annimmt, und zum Unveränderthalten des an seinem Ausgang anliegenden Signals, wenn das an seinem zweiten Eingang anliegende Signal einen zweiten Wert komplementär zum ersten annimmt; und
- mehrere Flipflops (B1, B2, B3), die in zwei geteilt montiert und in Kaskade geschaltet sind, wobei ein Takteingang des ersten dieser Flipflops mit dem Ausgang des Speicherelements verbunden ist.

5. Leseschaltung nach einem der vorherigen Ansprüche, bei der jede Frequenzvervielfacherschaltung einen digitalen Phasenregelkreis umfasst, der einen Frequenzteiler in seiner Rückkoppelungsschleife umfasst.

6. Leseschaltung nach einem der vorherigen Ansprüche, wobei ein Abtast- und Haltekreis (SH) am Eingang (E1) jeder Spannung-in-Verzögerung-Wandlerschaltung vorgesehen ist.

7. Leseschaltung nach einem der vorherigen Ansprüche, die auch einen Generator (GH) des primären Taktsignals umfasst, verbunden mit der gemeinsamen Taktübertragungsleitung.

8. Leseschaltung nach einem der vorherigen Ansprüche, bei der die Frequenzvervielfacherschaltungen einen Multiplikationsfaktor zwischen 2 und 16 haben.

9. Bildsensor, der einen Pixelmatrixsensor (MPA) umfasst, umfassend mehrere Pixel (PX), angeordnet in Reihen und Spalten, wobei jede Spalte (C1, C2, C3) einen jeweiligen Leseleiter (LC, LC1 - LC3) aufweist, und eine Leseschaltung (CL) für die Matrix nach einem der vorherigen Ansprüche, wobei die Eingänge der Spannung-in-Verzögerung-Wandlerschaltungen der Leseschaltung mit den jeweiligen Leseleitem von Pixelspalten der Matrix verbunden sind.

10. Bildsensor nach Anspruch 9, bei dem der Pixelmatrixsensor und die Leseschaltung auf monolithische Weise gemeinsam integriert sind.

11. Bildsensor nach Anspruch 9 oder 10, wobei die Pixel aktive Pixel sind.

## Claims

1. A circuit (CL) for reading a sensor including a pixel matrix array (MPA), said circuit comprising:
a plurality of voltage-to-delay converting circuits configured to receive, on an input (E1), a voltage value representative of the voltage of a read conductor (LC, LC1 - LC3) of a respective column (C1 - C3) of pixels (PX) of said matrix array and to deliver as output a binary signal called a comparative signal (SBC), this signal being switched at a time dependent on the input voltage value;
**characterized in that** it also comprises:
- a plurality of frequency-multiplying circuits (CMF1 - CMF3), each associated with a group of at least one said voltage-to-delay converting circuit, having respective inputs connected to a common clock transmission line (LH) that is intended to propagate a clock signal (HP) called a primary clock signal, and respective outputs for clock signals (HS, HS1 - HS3), called secondary clock signals, of the primary clock signal, that are of a frequency that is a multiple of said primary clock signal, these circuits being configured to multiply the frequency of the primary clock signal present on their input by the same multiplicative factor; and
a plurality of binary counters (CBN, CBN1 - CBN3), one for each of said voltage-to-delay converting circuits, having a same number of counting bits and configured to receive, on a first input (D), a said secondary clock signal, and, on a second input (CLK), the binary comparative signal delivered by the corresponding voltage-to-delay converting circuit, each of said counters being configured to count at a rate dictated by said secondary clock signal until said binary comparative signal switches.

2. The read circuit as claimed in claim 1, wherein each of said voltage-to-delay converting circuits is of the single ramp type and comprises a generator of a linear voltage ramp and an analog comparator configured to compare a constant voltage to said linear voltage ramp.

3. The read circuit as claimed in either of the preceding claims, wherein each of said frequency-multiplying circuits is associated with one and only one voltage-to-delay converting circuit.

4. The read circuit as claimed in one of the preceding claims, wherein each of said binary counters is a natural binary counter comprising:
a latch-type memory element (B0) having a first input configured to receive a said secondary clock signal and forming said first input of the natural binary counter, a second input configured to receive the binary comparative signal delivered by the corresponding voltage-to-delay converting circuit, and an output, said memory element being configured to transmit, to its output, the signal (HS) present on its first input when the signal (SBC) present on its second input takes a first value, and to maintain unchanged the signal present on its output when the signal present on its second input takes a second value complementary to the first; and
a plurality of divide-by-2 flip-flops (B1, B2, B3) connected in cascade, a clock input of the first of these flip-flops being connected to the output of said memory element.

5. The read circuit as claimed in one of the preceding claims, wherein each of said frequency-multiplying circuits comprises a digital phase-locked loop including a frequency divider in its feedback loop.

6. The read circuit as claimed in one of the preceding claims, wherein a sample-and-hold circuit (SH) is arranged on the input (E1) of each of said voltage-to-delay converting circuits.

7. The read circuit as claimed in one of the preceding claims, also comprising a generator (GH) of said primary clock signal, connected to said common clock transmission line.

8. The read circuit as claimed in one of the preceding claims, wherein said frequency-multiplying circuits have a multiplicative factor comprised between 2 and 16.

9. An image sensor comprising a sensor including a pixel matrix array (MPA), comprising a plurality of pixels (PX) arranged in rows and columns, each of said columns (C1, C2, C3) having a respective read conductor (LC, LC1 - LC3), and a circuit (CL) for reading said matrix array as claimed in one of the preceding claims, said inputs of the voltage-to-delay converting circuits of said read circuit being connected to respective read conductors of the columns of pixels of the matrix array.

10. The image sensor as claimed in claim 9, wherein said sensor including a pixel matrix array and said read circuit are co-integrated monolithically.

11. The image sensor as claimed in either of claims 9 or 10, wherein said pixels are active pixels.
